# EUROPÄISCHE PATENTANMELDUNG

(11) **EP 1 420 446 A1**
(43) Veröffentlichungstag der Anmeldung: **19.05.2004**
(21) Anmeldenummer: 03450222.9
(22) Anmeldetag: 03.10.2003
(51) Int. Cl.: H01L 23/373

(54) **Bauteil zur Wärmeableitung**

(30) Priorität: 12.11.2002 AT 17052002
(71) Anmelder: ELECTROVAC, FABRIKATION ELEKTROTECHNISCHER SPEZIALARTIKEL GESELLSCHAFT M.B.H., 3400 Klosterneuburg (AT)
(72) Erfinder: Schmitt, Theodore Nicolas Dr., 1230 Wien (AT); Mauthner, Klaus Dieter Dr., 9131 Grafenstein (AT); Hammel, Ernst Dr., 1140 Wien (AT)
(74) Vertreter: Gibler, Ferdinand, Dipl.Ing. Dr.

(57) **Zusammenfassung**

Bauteil zur Wärmeableitung, das zumindest teilweise aus einem Verbundwerkstoff (2) gebildet ist, welcher in wenigstens zwei Richtungen einen thermischen Ausdehnungskoeffizienten a zwischen 30° C und 250° C im Bereich von 2 bis 13.10 ⁻⁶ K ⁻¹, eine Volumensmasse unter 3000 kg . m ⁻³ und eine Leitfähigkeit λ über oder gleich 113 W.m⁻¹ · K ⁻¹ aufweist, und welcher von einer Matrix aus einem Metall oder von einer Matrix aus Polymeren oder Harzen und Verstärkungselementen gebildet wird, wobei die Verstärkungselemente zumindest durch Microfasern und Nanofasern gebildet sind, wobei auf den Verbundwerkstoff (2) eine zusätzliche Oberflächenschicht (1) aufgebracht ist, und daß die zusätzliche Oberflächenschicht (1) zur Gänze oder teilweise metallischen Charakter aufweist.

## Beschreibung

Die Erfindung betrifft ein Bauteil zur Wärmeableitung, das zumindest teilweise aus einem Verbundwerkstoff gebildet ist, welcher in wenigstens zwei Richtungen einen thermischen Ausdehnungskoeffizienten α zwischen 30° C und 250° C im Bereich von 2 bis 13.10⁻⁶ K ⁻¹, eine Volumensmasse unter 3000 kg.m ⁻³ und eine Leitfähigkeit λ über oder gleich 113 W.m⁻¹ ^{.} K⁻¹ aufweist, und welcher von einer Matrix aus einem unter dem reinen Aluminium, dem reinen Magnesium, dem reinen Kupfer und deren Legierungen gewählten Metall oder von einer Matrix aus Kupfer-Wolfram bzw. Kupfer-Molybdän oder von einer Matrix aus Polymeren oder Harzen und Verstärkungselementen gebildet wird, wobei die Verstärkungselemente zumindest durch Microfasem gemäß einem Volumenanteil im Bereich von 5 bis 90% und Nanofasern gemäß einem Volumenanteil im Bereich von 1 bis 60% gebildet sind, wobei der Verbundwerkstoff aus der Infiltration des Verstärkungselements entweder durch das Metall im flüssigen Zustand oder den Polymeren bzw. Harzen im ebenfalls fluessigen bzw. nicht ausgehärteten Zustand resultiert.

Verbundwerkstoffe als Konstruktionswerkstoffe haben sich in Sparten, wo hohe mechanische Beanspruchung jedoch möglichst geringes Gewicht gefordert ist, wie z.B. im Flugzeugbau oder der Sportartikelindustrie, allgemein durchgesetzt. Neben Konstruktionsteilen haben Verbundwerkstoffe auch in der Elektronikindustrie als Trägersubstrate ein breites Anwendungsspektrum erfahren. Dies aufgrund der Möglichkeit durch gezielte Auswahl der einzelnen Komponenten mechanische und, für diese Anwendung bei Weitem wichtiger, thermische Eigenschaften optimal einzustellen. Im Regelfall besteht ein Verbundwerkstoff für Thermal-Management-Applikationen aus einer duktilen Matrix, welche sowohl ein Metall als auch ein organisches Polymer sein kann, und einer sich von der Matrix strukturell unterscheidenden Füllkomponente.

"Materials for Thermal Conduction", Chung et al., Appl. Therm. Eng., 21, (2001) 1593 - 1605, gibt einen Überblick über Materialien für Wärmeleitungs- bzw. Wärmeableitungsmaterialien. Der Artikel skizziert die Eigenschaften möglicher Einzelkomponenten und relevante Beispiele für Verbundwerkstoffe. Ting et al. berichtet in J. Mater. Res., 10 (6), 1995, 1478 - 1484 über die Herstellung von Aluminium VGCF (Vapor Grown Carbon Fiber)-Verbundwerkstoffen und deren Wärmeleiteigenschaften. Die US 5,814,408 Ting et al. ist die daraus folgende Patentschrift zum Al-VGCF MMC. Verbundwerkstoffe mit Carbon Fibrils™, einer definierten CVD-Kohlenstoffaser, in sowohl Metall- als auch Polymer- Matrix wurden zuvor schon in der US 5,578,543 Hoch et al. erwähnt. Ushijima et al. beschreibt in der US 6,406,790 die Herstellung eines Verbundwerkstoffes mit einer speziellen Ausführung von CVD gewachsenen Kohlenstoffasern als Füllstoff mittels Druckinfiltration des Matrix-Metalles. Houle et al. berichtet in der US 6,469,381 von einem Halbleiterelement, welches die im Betrieb entstehende Wärme durch den Einbau von Carbon Fasern in die Trägerplatte ableitet. Die Verwendung von beschichteten Carbon-Fasern in Verbundwerkstoffen mit metallischer Matrix wird von Bieler et al. in der US 5,660,923 dargelegt. Al₂O₃ Fasern in einer A1 Matrix und die Herstellung des entsprechenden faserverstärkten Verbundwekstoffes beschreibt die US 6,460,597, McCullough et al..

Bauteile zur Wärmeableitung im Sinne der Erfindung umfassen Aufbauten, wie z.B. Ableitböden, Träger und Polstücke von Leistungskreisen, Laserdiodenträger, Wärmeableiter und Einkapselungsgehäuse von Leistungsmikroelektronik-Hybridkreisen oder Hyperfrequenzkreisen. Auch sind hierunter von Kühlmedium, z.B. Wasser durchflossene Mikrokühler, Heat-Sinks auf Leiterplatten, Heat-Pipes oder dergleichen zu verstehen.
Bei elektronischen Bauteilen sind solche Bauteile zur Wärmeableitung im allgemeinen mit isolierenden Substraten aus Keramik, wie z.B. Alumiumoxid oder mit Halbleitern, wie z.B. Slizium oder Galliumarsenid verbunden.
Der Betrieb dieser elektronischen Bauteile kann zu einer erheblichen Wärmeabgabe führen. Es ist daher, um sie nicht durch eine übermäßige Erhitzung zu beeinträchtigen, erforderlich, die abgegebene Wärme möglichst rasch abzuführen. Hierzu setzt man einen Verbundwerkstoffhoher Wärmeleitfähigkeit λ, d.h. wenigstens über 60 W.m⁻¹.K⁻¹ ein.
Trotz allem ergibt sich eine Temperaturerhöhung, und wenn der Ausdehnungskoeffizient α des Verbundwerkstoffes zu verschieden von dem des Keramiksubstrates ist, entwickeln sich in letzterem Beanspruchungen über der Festigkeit der Keramik und daher Brüche, die der Leitfähigkeit der Anordnung und ihrer elektrischen Isolation schaden. Daher ist es ebenfalls erforderlich, daß der Verbundwerkstoff einen mit dem des Aluminiumoxids kompatiblen Ausdehnungskoeffizienten, vorzugsweise unter 16.10⁻⁶ K ⁻¹ im Temperaturbereich von 30-400° C, hat.
Andererseits führt die eventuelle Verwendung dieser Schaltkreise in Fahrzeugen dazu, nach Materialien zu suchen, die eine möglichst niedrige Volumenmasse von vorzugsweise unter 3000 kg . m ⁻³ haben, um den für ihre Fortbewegung erforderlichen Energieverbrauch möglichst weit zu verringern.
Außerdem wünscht man, da die Schaltkreise gegenüber der Umgebung empfindlich sind, daß das Material einen geeigneten amagnetischen Charakter sowie eine gute Dichtheit gegenüber dem äußeren Medium hat.
Die Herstellung eines Materials, das einen Kompromiß zwischen allen diesen Eigenschaften aufweist, war Gegenstand zahlreicher Untersuchungen.
Auf einem faserverstärkten Verbundwerkstoff ist es allerdings nicht möglich, die elektronischen Komponenten fest zu verankern. Speziell Kohlenstoff welcher herstellungsbedingt an der Originaloberfläche gegenwärtig ist, verhindert das Anbringen von Schaltungen, Transistoren und dgl., da Kohlenstoff von Metallen oder Legierungen, welche in der Elektronik als Lote verwendet werden, nicht benetzt wird. Im Falle von A1 bzw. dessen Legierungen beeinträchtigt die Autopassivierung des Aluminiums durch Oberflächenoxidbildung das direkte Anbringen der Elektronikkomponenten am wärmeableitenden Substrat.

Aufgabe der Erfindung ist es daher, ein Bauteil zur Wärmeableitung der eingangs genannten Art anzugeben, mit dem die vorstehend genannten Nachteile überwunden werden können.

Erfindungsgemäß wird dies dadurch erreicht, daß auf den Verbundwerkstoff eine zusätzliche Oberflächenschicht aufgebracht ist, und daß die zusätzliche Oberflächenschicht zur Gänze oder teilweise metallischen Charakter aufweist.

Der wärmeableitende Verbundwerkstoff wird dabei nach der Herstellung und/oder Bearbeitung alsbald mit einer geeigneten metallischen gut haftenden Oberfläche ausgestattet, welche zum einen die dem Stand der Technik entsprechenden Montageprozesse erlaubt, zum anderen dem wärmeableitenden auf Metallmatrix basierenden Verbundwerkstoff ausreichenden Korrosionsschutz verleiht. Im Falle metallgebundener Verbundwerkstoffe wird der korrosive Angriff von feuchter Luft, sauren bzw. basischen Nebeln und reaktiven Gasen verhindert. Bei den polymerinfiltrierten Substratmaterialien wird durch die erfindungsgemäße Oberfläche der Konstruktionsteil zusätzlich gegen organische Agenzien geschützt, wie z.B. Ölnebel, halogenierte Lösungsmittel etc..
Die erfindungsgemäße zusätzliche Oberflächenschicht dient dem Aufbringen von elektronischen Komponenten durch z.B. Löten und gewährleistet, gegebenenfalls, hinreichend Korrosionsschutz für das angesprochene Substratmaterial.
In weiterer Ausbildung der Erfindung kann die zusätzliche Oberflächenschicht aus Metall oder Metallegierung bestehen, wobei bevorzugt das Metall oder die Metallegierung aus Ni, Cu, Au, Ag, Ti, Al, V, Mo oder W bzw. deren Legierungen gebildet sein können.
Die Aufbringung des jeweiligen Metalls oder der jeweiligen Metallegierung kann daher im Rahmen bekannter Oberflächenbeschichtungsverfahren durchgeführt werden.
So kann die zusätzliche Oberflächenschicht in weiterer Ausbildung der Erfindung mittels elektrochemischer, chemischer und/oder physikalischer Verfahren aufgebracht werden.
Alternativ dazu kann die zusätzliche Oberflächenschicht durch Sputtern oder durch Walzplattieren aufgebracht werden. Diese Verfahren können auch in Serienproduktionen Anwendung finden.
Eine weitere Ausführungsform der Erfindung kann darin bestehen, daß die zusätzliche Oberflächenschicht zur Gänze oder teilweise aus Ni, Ni-B, Ni-P und Ni-Legierungen besteht, welche sich durch eine besonders gute Haftfähigkeit auf Verbundwerkstoffen auszeichnen.
In den bisher durchgeführten Experimenten hat es sich weiters als vorteilhaft für die Hafteigenschaften der zusätzlichen Oberflächenschicht herausgestellt, diese mit einer Schichtdicke von wenigen Nanometern bis zu einigen Millimetern auszubilden, in besonders bevorzugter Weise ist eine Schichtdicke von einigen Mikrometern anzusehen.
Weiters kann in weiterer Ausgestaltung der Erfindung die zusätzliche Oberflächenschicht, insbesondere durch Ätzen strukturiert sein, was durch den metallischen Charakter der erfindungsgemäßen Oberflächenschicht erleichtert wird.
Der als Grundlage für die Aufbringung der zusätzlichen Oberflächenschicht dienende Verbundwerkstoff kann Kohlenstoffasern umfassen, wobei ein Ausmaß von 5 bis 90% Vorteile bei der Herstellung erbringen kann. Der Durchmesser der Kohlenstoffasern kann dabei mit Durchmessern größer als 1µm, vorzugsweise von 5 bis 15µm gebildet sein, wodurch die Verbundeigenschaften des Verbundkörpers positiv beeinflußt werden können.
Die Kohlenstoffasern können verschiedenartig ausgeführt sein, eine mögliche Variante kann darin bestehen, sie aus grafitiertem Polyacrylnitril und/oder Pitch auszubilden.
Es können die Kohlenstofffasern sowohl eindimensional, als auch als zweidimensionales oder dreidimensionales Netzwerk in die Metallmatrix eingebaut sein.
Eine alternative Ausführungsform der Erfindung kann weiters darin bestehen, daß der Verbundwerkstoff im Ausmaß von 1 bis 90% aus Mikrofasern mit Durchmessern kleiner 5µm gebildet ist.
Weiters kann der Verbundwerkstoff im Ausmaß von 1 bis 60% aus Nanofasern mit Durchmessern von kleiner 1µm gebildet sein.

Nanotubes, welche zur Familie der Nanofasern zählen, sind zylindrische einoder mehrlagige Kohlenstoff-Röhren mit einem Durchmesser von 1 - 30 nm. Mit Hilfe von Nanotubes wird eine Mikro- bzw. Nanostrukturierung des Vernbundwerkstoffes erreicht, was zu einem die Wärmeleitfähigkeit wesentlich verbessernden, vergrößerten aktiven Volumen führt. Darüberhinaus gewährleisten Nanotubes aufgrund ihrer ausgezeichneten mechanischen Eigenschaften eine ausreichende Stabilität des Materials, ermöglichen aber dennoch hervorragende Bearbeitbarkeit des Materials.

Wird gemäß einer Ausgestaltung der Erfindung der Verbundwerkstoff im Ausmaß von 1 bis 60% aus Nanofasern, insbesondere aus Kohlenstoffnanofasern, mit Durchmessern von kleiner 300 nm gebildet, so ergibt sich daraus eine Verbesserung der mechanischen und thermischen Eigenschaften dieses Werkstoffes. Die Kohlenstoffnanofasern können dabei bevorzugt mittels katalysatorunterstützter Abscheidung von Kohlenstoff aus der Gasphase hergestellt werden.

Eine besonders hohe Wärmeleitfähigkeit des Verbundwerkstoffes läßt sich erzielen, wenn gemäß einer weiteren Ausführungsform der Erfindung Kohlenstoffnanofasern einen hohlen inneren Kanal aufweisen.

Eine weitere Variation der Bestandteile des Verbundwerkstoffes kann darin bestehen, daß die Kohlenstofffasern neben Kohlenstoff auch Bor und/oder Stickstoff beinhalten, wodurch die Wärmeleitfähigkeit in entscheidender Weise verbessert werden kann.

Insbesondere kann der Verbundwerkstoff im Ausmaß von 1 bis 60% aus Bor-Nanofasem oder BN-Nanofasern mit Durchmessern von kleiner 300 nm gebildet sein.

Eine andere Möglichkeit die Festigkeit und die Wärmeleitfähigkeit des Verbundwerkstoffes zu erhöhen kann darin bestehen, daß dieser im Ausmaß von 1 bis 60% aus Nanofasern mit Durchmessern von kleiner 300 nm gebildet ist, welche aus MoS₂, WS₂, NbS₂, TaS₂ und V₂O₅ in der Form von mehrwandigen Nanotubes aufgebaut sind.

Eine weitere bevorzugte Ausführungsform zur Erhöhung der thermischen Leitfähigkeit kann durch Ausbildung des Verbundwerkstoff im Ausmaß von 1 bis 60% aus Nanofasern gegeben sein, wobei die Fasern aus einer einzigen Atomlage röhrenförmig aufgebaut sind.

Eine andere Ausgestaltung der Erfindung ermöglicht ebenfalls sowohl eine bessere Wärmeleitfähigkeit als auch eine bessere mechanische Festigkeit des Verbundwerkstoffes, indem dieser im Ausmaß von 1 bis 90% aus Microfasern mit Durchmessern von größer 1 µm gebildet ist, welche aus Glas oder Keramik sind, wobei die Glas- oder Keramik-Fasern in bevorzugter Weise eine durchgehende metallische Schichte aufweisen.

Das erfindungsgemäße Bauteil kann in vielfacher Weise zur Wärmeableitung eingesetzt werden. Es kann das erfindungsgemäße Bauteil ein mit Flüssigkeit durchströmtes Kühlelement angebaut sein, welches die Wärmeabfuhr zusätzlich verbessert. In alternativer Ausführungsform kann das erfindungsgemäße Bauteil als ein mit Flüssigkeit durchströmtes Kühlelement ausgebildet sein.

Eine Anwendungsmöglichkeit des erfindungsgemäßen Bauteils besteht darin, es als Heatpipe auszubilden oder an eine Heatpipe zu koppeln.

Eine Variante des erfindungsgemäßen Bauteils kann gasdurchströmbare Kühlrippen aufweisen, um eine Kühlung z.B. durch Umgebungsluft zu ermöglichen.

Das erfindungsgemäße Bauteil kann als Teil eines elektronischen Bauteils, als Elektronikgehäuse oder als hermetisch verschlossenes Gehäuse ausgebildet sein, um die Ableitung der in diesem entstehenden Wärme zu ermöglichen. Es kann als Chipdeckel, als Grundplatte für IGBT, als Grundplatte für Thyristoren, als Grundplatte für Laserdioden ausgebildet sein.

Eine weitere Ausführungsform der Erfindung kann darin bestehen, daß das erfindungsgemäße Bauteil als Träger bzw. Konstruktionsmaterial ausgebildet ist und thermischer Wechselbeanspruchung widersteht.

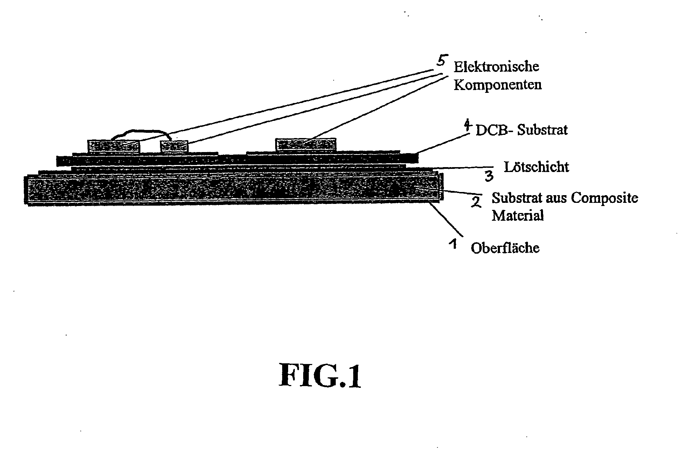

Schließlich kann eine Ausführungsform der Erfindung darin bestehen, daß der Metall-Matrix-gebundene Verbundwerkstoff-Kern von Matrixmetall umgossen ist.
Nachfolgend wird die Erfindung anhand des in der Zeichnung dargestellten Ausführungsbeispiels in nicht einschränkender Weise eingehend erläutert. Fig.1 zeigt eine Seitenansicht einer Ausführungsform des erfindungsgemäßen Bauteils.
Fig.1 zeigt einen Verbundwerkstoff 2, der ein Bauteil zur Wärmeableitung bildet, auf dem elektronische Bauteile 5 angebracht sind, welche während ihres Betriebs durch die auftretende Verlustleistung Wärme abgeben, deren Ableitung durch das Wärmeableitungs-Bauteil in erhöhtem Ausmaß gegeben ist. Erfindungsgemäß ist auf den Verbundwerkstoff eine zusätzliche Oberflächenschicht 1 aufgebracht, welche zur Gänze oder teilweise metallischen Charakter aufweist.
Die Oberflächenschicht kann den Verbundwerkstoff vollständig oder auch nur teilweise bedecken und ermöglicht vor allem die Haftverbesserung der Verbundwerkstoff-Oberfläche, sodaß z.B. eine Lötschicht 3 haftend aufgebracht werden kann, über welche eine starre Befestigung der elektronischen Bauteile 5 erzielt werden kann. Im gezeigten Ausführungsbeispiel ist zwischen den Bauteilen 5 und der zusätzlichen Oberflächenschicht 1 ein DCB (Direct Copper Bonding)-Substrat 4 vorgesehen, um eine sichere und thermisch gut leitfähige Verbindungsschicht zu gewährleisten. Es können die Bauteile 5 aber auch direkt mit der zusätzlichen Oberflächenschicht 1 verlötet sein.
Der Verbundwerkstoff weist in wenigstens zwei Richtungen einen Dehnungskoeffizienten α zwischen 30° C und 250° C im Bereich von 2 bis 13.10 ⁻⁶ . K ⁻¹, eine Volumensmasse unter 3000 kg.m ⁻³ und eine Leitfähigkeit λ über oder gleich 113 W.m⁻¹. K⁻¹ auf und wird von einer Matrix aus einem unter dem reinen Aluminium, dem reinen Magnesium, dem reinen Kupfer und deren Legierungen gewählten Metall oder von einer Matrix aus Polymeren oder Harzen und Verstärkungselementen gebildet, wobei die Verstärkungselemente aus einem Filz oder einer Vorform von Microfasern in einem Volumensanteil im Bereich von 5 bis 90% und
Nanofasern in einem Volumenanteil im Bereich von 1 bis 60% gebildet sind, wobei der Verbundwerkstoff aus der Infiltration des Verstärkungselements entweder durch das Metall im flüssigen Zustand, oder den Polymeren bzw. Harzen im plastizierten bzw. nicht ausgehärteten Zustand resultiert.
Zufolge der verwendeten Nanotubes werden die Hohlräume des Filzes bzw. der Vorform optimal mit Kohlenstoffanteilen in Form von Nanotubes unter Ausbildung einer optimalen Mikro/Nanostruktur besetzt. Die metallische Matrix, in welcher die Teilchen und gegebenenfalls Fasern sowie die Nanofasern verteilt sind, kann aus reinem Aluminium, reinem Magnesium, reinem Kupfer oder deren Legierungen bestehen. Diese Metalle gewährleisten eine gute Leitfähigkeit, eine geringe Dichte und einen geringen Schmelzpunkt. Im Fall der Aluminiumlegierungen verwendet man diejenigen, die wenig mit Zusatzelementen versetzt sind: Zink, Kupfer, Magnesium, Eisen und Nickel können in geringer Menge toleriert werden; was Mangan, Titan, Vanadin und Lithium betrifft, so sind sie zu vermeiden. Vorzugsweise wählt man die Legierungen der Serien 1000, 5000 und 6000 nach den Normen der Aluminium Association sowie Gußlegierungen der Serie 4000 und unter diesen letzteren insbesondere solche, die 7, 10 und 13 % Silizium enthalten, wie die Legierungen AA 356, AA 357 und AA 413,2, und unter denen der Serie 6000 die Legierungen 6061 und 6101. Im Fall der faserverstärkten, wärmeabfuehrenden, polymergebundenen Materialien sind sowohl Thermoplaste, wie PET (Polyethylenterephtalat), PMMA (Polymethylmetacrylat), PC (Polycarbonat), PA (Polyamide), etc., und Duroplaste, wie PUR (Polyuretrhan), PF (Phenol-Formaldehyd-Harze), MF (Melamin-Formaldehyd-Harze), EP (Epoxy-Harze), etc., als mögliche Matrixmaterialien erwähnt. Die Herstellung der Nanotubes/Nanofasern erfolgt vorzugsweise, soll jedoch nicht nur auf dieses Verfahren eingeschränkt sein, nach dem CCVD-Verfahren (catalytical chemical vapor desposition), da dieses Verfahren nach dem Stand der Technik ausreichende Mengen an Material für technische Anwendungen garantiert.
In der in Fig.1 gezeigten Ausführungsform besteht die zusätzliche Oberflächenschicht aus Metall oder aus einer Metallegierung, wobei das Metall oder die Metallegierung bevorzugt aus Ni, Cu, Au, Ag, Ti, Al, V, Mo oder W bzw. deren Legierungen gebildet sind.
Es kann aber die zusätzliche Oberflächenschicht z.B. auch zur Gänze oder teilweise aus Ni, Ni-B, Ni-P und Ni-Legierungen bestehen.
Die zur Aufbringung der zusätzlichen Oberflächenschicht 1 anwendbaren Verfahren reichen von elektrochemischen, chemischen bis hin zu physikalischen Verfahren, insbesondere Sputtern und Walzplattieren.
Die Schichtdicke der Oberflächenschicht 1 kann von wenigen Nanometern bis zu einigen Millimetern betragen, sie kann, z.B. durch Ätzen, in geeigneter Weise strukturiert werden.
Der Verbundwerkstoff kann ohne einschränkende Wirkung folgende Bestandteile umfassen:

### BEISPIEL 1

5 bis 90% aus Kohlenstofffasern mit Durchmessern von größer 1µm.

### BEISPIEL 2

5 bis 90% aus Kohlenstofffasern mit Durchmessern von 5 bis 15µm.
Die Kohlenstofffasern können neben Kohlenstoff auch Bor und/oder Stickstoff enthalten.

### BEISPIEL 3

1 bis 90% aus Mikrofasern mit Durchmessern kleiner 5µm.

### BEISPIEL 4

Kohlenstofffasern aus grafitiertem Polyacrylnitril und/oder Pitch.

### BEISPIEL 5

1 bis 60% aus Nanofasern mit Durchmessern von kleiner 1µm.

### BEISPIEL 6

1 bis 60% aus Nanofasern mit Durchmessern von kleiner 300 nm.

### BEISPIEL 7

1 bis 60% aus Kohlenstoffnanofasern mit Durchmessern von kleiner 300 nm, welche mittels katalysatorunterstützter Abscheidung von Kohlenstoff aus der Gasphase hergestellt sind. Die Kohlenstoffnanofasern können einen hohlen inneren Kanal aufweisen.

### BEISPIEL 8

1 bis 60% aus Bor-Nanofasern oder BN-Nanofasern mit Durchmessern von kleiner 300 nm.

### BEISPIEL 9

1 bis 60% aus Nanofasern mit Durchmessern von kleiner 300 nm, welche aus MoS₂, WS₂, NbS₂, TaS₂ und V₂O₅ in der Form von mehrwandigen Nanotubes aufgebaut sind.

### BEISPIEL 10

1 bis 60% aus Nanofasern, wobei die Fasern aus einer einzigen Atomlage röhrenförmig aufgebaut sind.

### BEISPIEL 11

1 bis 90% aus Microfasern mit Durchmessern von größer 1 µm, welche aus Glas oder Keramik sind.

Das erfindungsgemäße Bauteil kann zur verbesserten Wärmeabfuhr und Wärmespreizung dienen. Es kann an das erfindungsgemäße Bauteil ein mit Flüssigkeit durchströmtes Kühlelement angebaut sein oder es kann als ein mit Flüssigkeit durchströmtes Kühlelement ausgebildet sein. Das erfindungsgemäße Bauteil kann als Heatpipe ausgebildet sein oder es kann an eine Heatpipe gekoppelt sein.
Zur verbesserten Kühlmittelzufuhr kann das erfindungsgemäße Bauteil mit gasdurchströmbaren Kühlrippen ausgestattet sein. Weiters kann das erfindungsgemäße Bauteil auch Teil eines elektronischen Bauteils sein, es kann als Chipdeckel, als Grundplatte für IGBT, als Grundplatte für Thyristoren, als Grundplatte für Laserdioden ausgebildet oder als Elektronikgehäuse ausgebildet sein. Es besteht auch die Möglichkeit, das erfindungsgemäße Bauteil in Form eines hermetisch verschlossenen Gehäuses auszubilden.
Schließlich kann das erfindungsgemäße Bauteil als Träger bzw. Konstruktionsmaterial ausgebildet sein und dabei thermischer Wechselbeanspruchung widerstehen.

## Patentansprüche

1. Bauteil zur Wärmeableitung, das zumindest teilweise aus einem Verbundwerkstoff gebildet ist, welcher in wenigstens zwei Richtungen einen thermischen Ausdehnungskoeffizienten α zwischen 30° C und 250° C im Bereich von 2 bis 13.10⁻⁶ K⁻¹, eine Volumensmasse unter 3000 kg . m ⁻³ und eine Leitfähigkeit λ über oder gleich 113 W.m ^{-1 .} K ⁻¹ aufweist, und welcher von einer Matrix aus einem unter dem reinen Aluminium, dem reinen Magnesium, dem reinen Kupfer und deren Legierungen gewählten Metall oder von einer Matrix aus Kupfer-Wolfram bzw. Kupfer-Molybdän oder von einer Matrix aus Polymeren oder Harzen und Verstärkungselementen gebildet wird, wobei die Verstärkungselemente zumindest durch Microfasern gemäß einem Volumenanteil im Bereich von 5 bis 90% und Nanofasern gemäß einem Volumenanteil im Bereich von 1 bis 60% gebildet sind, wobei der Verbundwerkstoff aus der Infiltration des Verstärkungselements entweder durch das Metall im flüssigen Zustand oder den Polymeren bzw. Harzen im ebenfalls fluessigen bzw. nicht ausgehärteten Zustand resultiert, **dadurch gekennzeichnet, daß** auf den Verbundwerkstoff (2) eine zusätzliche Oberflächenschicht (1) aufgebracht ist, und daß die zusätzliche Oberflächenschicht (1) zur Gänze oder teilweise metallischen Charakter aufweist.

2. Bauteil nach Anspruch 1, **dadurch gekennzeichnet, daß** die zusätzliche Oberflächenschicht aus Metall oder Metallegierung besteht.

3. Bauteil nach Anspruch 2, **dadurch gekennzeichnet, daß** das Metall oder die Metallegierung aus Ni, Cu, Au, Ag, Ti, Al, V, Mo oder W bzw. deren Legierungen gebildet ist.

4. Bauteil nach Anspruch 2, **dadurch gekennzeichnet, daß** die zusätzliche Oberflächenschicht zur Gänze oder teilweise aus Ni, Ni-B, Ni-P und Ni-Legierungen besteht.

5. Bauteil nach einem der vorhergehenden Ansprüche, **dadurch gekennzeichnet, daß** die zusätzliche Oberflächenschicht mittels elektrochemischen, chemischen und/oder physikalischen Verfahren aufgebracht ist.

6. Bauteil nach einem der Ansprüche 1 bis 4, **dadurch gekennzeichnet, daß** die zusätzliche Oberflächenschicht elektrochemisch aufgebracht ist.

7. Bauteil nach einem der Ansprüche 1 bis 4, **dadurch gekennzeichnet, daß** die zusätzliche Oberflächenschicht durch Sputtern aufgebracht ist.

8. Bauteil nach einem der Ansprüche 1 bis 4, **dadurch gekennzeichnet, daß** die zusätzliche Oberflächenschicht durch Walzplattieren aufgebracht ist.

9. Bauteil nach einem der Ansprüche 1 bis 8, **dadurch gekennzeichnet, daß** die zusätzliche Oberflächenschicht mit einer Schichtdicke von wenigen Nanometern bis zu einigen Millimetern ausgebildet ist.

10. Bauteil nach einem der Ansprüche 1 bis 8, **dadurch gekennzeichnet, daß** die zusätzliche Oberflächenschicht mit einer Schichtdicke von einigen Mikrometern ausgebildet ist.

11. Bauteil nach einem der Ansprüche 1 bis 10, **dadurch gekennzeichnet, daß** die zusätzliche Oberflächenschicht strukturiert ist.

12. Bauteil nach Anspruch 11, **dadurch gekennzeichnet, daß** die zusätzliche Oberflächenschicht durch Ätzen strukturiert ist.

13. Bauteil nach einem der vorhergehenden Ansprüche, **dadurch gekennzeichnet, daß** der Verbundwerkstoff im Ausmaß von 5 bis 90% aus Kohlenstofffasern mit Durchmessern von größer 1µm gebildet ist.

14. Bauteil nach einem der Ansprüche 1 bis 12, **dadurch gekennzeichnet, daß** der Verbundwerkstoff im Ausmaß von 5 bis 90% aus Kohlenstofffasern mit Durchmessern von 5 bis 15µm gebildet ist.

15. Bauteil nach einem der Ansprüche 1 bis 12, **dadurch gekennzeichnet, daß** der Verbundwerkstoff im Ausmaß von 1 bis 90% aus Mikrofasern mit Durchmessern kleiner 5µm gebildet ist.

16. Bauteil nach Anspruch 13 oder 14, **dadurch gekennzeichnet, daß** die Kohlenstofffasern aus grafitiertem Polyacrylnitril und/oder Pitch gebildet sind.

17. Bauteil nach Anspruch 13, 14 oder 15, **dadurch gekennzeichnet, daß** die Kohlenstofffasern sowohl eindimensional, als auch als zweidimensionales oder dreidimensionales Netzwerk in die Metallmatrix eingebaut sind.

18. Bauteil nach einem der Ansprüche 1 bis 12, **dadurch gekennzeichnet, daß** der Verbundwerkstoff im Ausmaß von 1 bis 60% aus Nanofasern mit Durchmessern von kleiner 1µm gebildet ist.

19. Bauteil nach einem der Ansprüche 1 bis 12, **dadurch gekennzeichnet, daß** der Verbundwerkstoff im Ausmaß von 1 bis 60% aus Nanofasern mit Durchmessern von kleiner 300 nm gebildet ist.

20. Bauteil nach einem der Ansprüche 1 bis 12, **dadurch gekennzeichnet, daß** der Verbundwerkstoff im Ausmaß von 1 bis 60% aus Kohlenstoffnanofasern mit Durchmessern von kleiner 300 nm gebildet ist, welche mittels katalysatorunterstützter Abscheidung von Kohlenstoff aus der Gasphase hergestellt sind.

21. Bauteil nach Anspruch 20, **dadurch gekennzeichnet, daß** die Kohlenstoffnanofasern einen hohlen inneren Kanal aufweisen.

22. Bauteil nach Anspruch 20 oder 21, **dadurch gekennzeichnet, daß** die Kohlenstofffasern neben Kohlenstoff auch Bor und/oder Stickstoff beinhalten.

23. Bauteil nach einem der Ansprüche 1 bis 12, **dadurch gekennzeichnet, daß** der Verbundwerkstoff im Ausmaß von 1 bis 60% aus Bor-Nanofasern oder BN-Nanofasem mit Durchmessern von kleiner 300 nm gebildet ist.

24. Bauteil nach einem der Ansprüche 1 bis 12, **dadurch gekennzeichnet, daß** der Verbundwerkstoff im Ausmaß von 1 bis 60% aus Nanofasern mit Durchmessern von kleiner 300 nm gebildet ist, welche aus MoS₂, WS₂, NbS₂, TaS₂ und V₂O₅ in der Form von mehrwandigen Nanotubes aufgebaut sind.

25. Bauteil nach einem der Ansprüche 1 bis 12, **dadurch gekennzeichnet, daß** der Verbundwerkstoff im Ausmaß von 1 bis 60% aus Nanofasern gebildet ist, wobei die Fasern aus einer einzigen Atomlage röhrenförmig aufgebaut sind.

26. Bauteil nach einem der Ansprüche 1 bis 12, **dadurch gekennzeichnet, daß** der Verbundwerkstoff im Ausmaß von 1 bis 90% aus Microfasern mit Durchmessern von größer 1 µm gebildet ist, welche aus Glas oder Keramik sind.

27. Bauteil nach Anspruch 26, **dadurch gekennzeichnet, daß** die Glas- oder Keramik-Fasern eine durchgehende metallische Schichte aufweisen.

28. Bauteil nach einem der vorhergehenden Ansprüche, **dadurch gekennzeichnet, daß** es zur Wärmespreizung dient.

29. Bauteil nach einem der vorhergehenden Ansprüche, **dadurch gekennzeichnet, daß** ein mit Flüssigkeit durchströmtes Kühlelement angebaut ist.

30. Bauteil nach einem der Ansprüche 1 bis 29, **dadurch gekennzeichnet, daß** es als ein mit Flüssigkeit durchströmtes Kühlelement ausgebildet ist.

31. Bauteil nach einem der vorhergehenden Ansprüche, **dadurch gekennzeichnet, daß** es als Heatpipe ausgebildet ist.

32. Bauteil nach einem der Ansprüche 1 bis 30, **dadurch gekennzeichnet, daß** es an eine Heatpipe gekoppelt ist.

33. Bauteil nach einem der vorhergehenden Ansprüche, **dadurch gekennzeichnet, daß** es mit gasdurchströmbaren Kühlrippen ausgebildet ist.

34. Bauteil nach einem der Ansprüche 1 bis 30, **dadurch gekennzeichnet, daß** es als Chipdeckel ausgebildet ist.

35. Bauteil nach einem der Ansprüche 1 bis 30, **dadurch gekennzeichnet, daß** es als Grundplatte für IGBT ausgebildet ist.

36. Bauteil nach einem der Ansprüche 1 bis 30, **dadurch gekennzeichnet, daß** es als Grundplatte für Thyristoren ausgebildet ist.

37. Bauteil nach einem der Ansprüche 1 bis 30, **dadurch gekennzeichnet, daß** es als Grundplatte für Laserdioden ausgebildet ist.

38. Bauteil nach einem der Ansprüche 1 bis 30, **dadurch gekennzeichnet, daß** es als Elektronikgehäuse ausgebildet ist.

39. Bauteil nach einem der Ansprüche 1 bis 30, **dadurch gekennzeichnet, daß** es als hermetisch verschlossenes Gehäuse ausgebildet ist.

40. Bauteil nach einem der Ansprüche 1 bis 30, **dadurch gekennzeichnet, daß** es als Träger bzw. Konstruktionsmaterial ausgebildet ist und thermischer Wechselbeanspruchung widersteht.

41. Bauteil nach einem der vorhergehenden Ansprüche, **dadurch gekennzeichnet, daß** der Metall-Matrix-gebundene Verbundwerkstoff-Kern von Matrixmetall umgossen ist.
